Europäisches Patentamt

European Patent Office

Office européen des brevets

(19)

(11) **EP 1 492 234 A2**

(12) **EUROPEAN PATENT APPLICATION**

(43) Date of publication:
**29.12.2004 Bulletin 2004/53**

(51) Int Cl.⁷: **H03K 17/22**

(21) Application number: **04014644.1**

(22) Date of filing: **22.06.2004**

| | |
|---|---|
| (84) Designated Contracting States: **AT BE BG CH CY CZ DE DK EE ES FI FR GB GR HU IE IT LI LU MC NL PL PT RO SE SI SK TR** Designated Extension States: **AL HR LT LV MK** | (72) Inventor: **Roy, Amit** **Sahibabad, UP (IN)** |
| (30) Priority: **26.06.2003 IN DE08422003** | (74) Representative: **Bosotti, Luciano** **c/o Buzzi, Notaro & Antonielli d'Oulx** **Via Maria Vittoria 18** **10123 Torino (IT)** |
| (71) Applicant: **STMicroelectronics Pvt. Ltd** **Noida 201 301, Uttar Pradesh (IN)** | |

(54) **Power on reset circuit**

(57)     The present invention provides an improved Power-On-reset (POR) circuit providing enhanced reliability and automatic power-down capability, comprising a supply voltage sensing circuit (IS1,P1,VCCS), a delay element (1) connected to the output of the supply voltage sensing circuit, and a switch (P2,N2) that activates the output POR signal when the output of the delay element indicates a reduced supply voltage and deactivates the POR output and provides feedback to reduce current through the supply voltage sensing circuit once the supply voltage is normal.

FIG 5 (PROPOSED CIRCUIT)

Printed by Jouve, 75001 PARIS (FR)

EP 1 492 234 A2

## Description

## Field of the Invention

This invention relate to the field of Power-on Reset circuits. In particular, it relates to an improved Power On Reset circuit that self powers down after performing its function.

## Background of the Invention

During power up it is required that electronic circuits should be in a known state to ensure proper functionality. This initialization is generally provided by Power-On-Reset (POR) circuitry. There are numerous Power-On-Reset (POR) solutions available. Most of them consume some finite current from the power supply even after the completion of the reset process. It is observed that in certain applications (low power application this unnecessary power drain is unacceptable. The power consume by these blocks can be saved by either switching off the clock to these blocks or by switching off its biasing voltage.

In existing low-power implementations of POR circuits the biasing voltage to the POR circuitry is stopped after the initialization of system. Generally this disabling signal is a digital signal which is either logic '1' or logic '0'. However this signal is itself in an undefined state on power on resulting in unreliable operation.

Fig.-1 shows one example of a conventional POR circuit. Resistor 'R' is connected at one end to the positive supply Vcc and at the other end to capacitor 'C'. The opposite end of capacitor 'C' is connected to supply Gnd. The junction of the resistor and capacitor 'Vin' connects to the input of inverter IV. The output of inverter IV provides the POR output.

Fig-2 shows the operation of the circuit of Fig-1. As the power supply voltage VDD rises, the voltage at the node Vin also rises as capacitor C charges through resistor R. Vin rises along a curve which is defined by the time constant determined by the values of R and C.

Initially the voltage at Vin is below the threshold voltage of inverter IV and correspondingly the output of the inverter is 'HIGH' providing an active POR signal. Vin rises along a curve which is defined by the time constant of the Resistor R and Capacitor C.

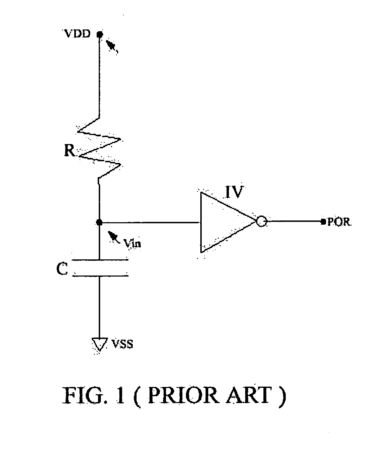

When the voltage at Vin crosses the threshold voltage of the inverter the output of the inverter goes 'low' causing the POR signal to be de-asserted. Generally the time constant of the RC network has to be kept fairly high compared to the Power supply rise time resulting in large values of R and C, Though the POR circuit of Fig1 as such does not consume any power after it the POR is de-asserted it is impractical to fabricate as an integrated circuit as the R and C require a very large area.

Fig-3 describes another POR, which is used quite frequently. PMOS transistor P1 is arranged in series with NMOS transistor N1. The gate Gp1 of PMOS transistor P1 is connected to ground, while its Source Sp1 is connected to power supply terminal VDD, and its Drain Dp1 is connected to node V1. Gate Gn1 and Drain Dn1 of NMOS transistor N1 are shorted together, and connected to node V1 while the source Sn1 is connected to the supply ground VSS. The gate GP2 of PMOS transistor P2 is connected to node V1, while its Drain Dp2 is connected to output POR and its source Sp2 is connected to power supply terminal VDD. NMOS transistor N2 has its gate Gn2 connected to node V1, Drain Dn2 connected to the output POR and source Sn2 connected to the power supply ground terminal VSS. When the Power supply VDD is applied, node V1 follows the VDD as long as it is less than the threshold voltage of N1 which remains off. As soon as the power supply VDD reaches the switching threshold Vtn of N1 and N2($Vtn1 = Vtn2$) both N1(working as a diode) and N2 turn ON and V2 goes to zero causing POR to be asserted. Further rise of power supply VDD will cause node V1 to rise because the difference in the current sunk by N1 and the current sourced by P1 will charge up the stray capacitance causing V1 to rise. As soon as V1 reaches the switching threshold Vtp2 V2 goes high and POR is de-asserted.

Fig-4 depicts the behavior of the circuit shown in Fig-3. The threshold voltage of transistor P2 is:

$$Vtp2 = V \text{ (voltage across the diode)} + Vtn$$

This circuit suffers from the drawback that it consumes power from the power supply even in the idle state and is therefore not suitable for low-power applications.

## Summary of the Invention:

The object of the invention is to obviate the above drawbacks and provide a Power-On-Reset (FOR) circuit that operates reliably at the time of application of the power and that powers itself down once the required reset pulse for the initialization of the remaining circuitry has been generated.

To achieve the said objective the present invention provides an improved Power-On-Reset (FOR) circuit that monitors the power supply voltage and employs a controlled feedback mechanism to ensure a proper reset pulse output even under the condition of a varying power supply voltage, and that powers itself down once the required power supply voltage has been achieved.

Accordingly, the improved Power-On-reset (FOR) circuit providing enhanced reliability and automatic power-down capability, comprising:

- a supply voltage sensing circuit,

- a delay element connected to the output of the supply voltage sensing circuit, and
- a controlled switch that activates the output FOR signal when the output of the delay element indicates a reduced supply voltage and deactivates the FOR output and provides controlled feedback to reduce current through the supply voltage sensing circuit once the supply voltage is normal.

The supply voltage sensing circuit is a constant current source connected to a current sink whose output is controlled by the feedback from the FOR output.

The delay element is a capacitor charged by the current difference between the constant current source and current sink.

The controlled switch disables the current sink when the supply voltage is normal

The constant current source is connected to the current sink through an isolating switch.

**Brief Description of the Accompanying Drawings:**

The invention will now be described with reference to the accompanying drawings:

Figure 1 shows a conventional FOR circuit.

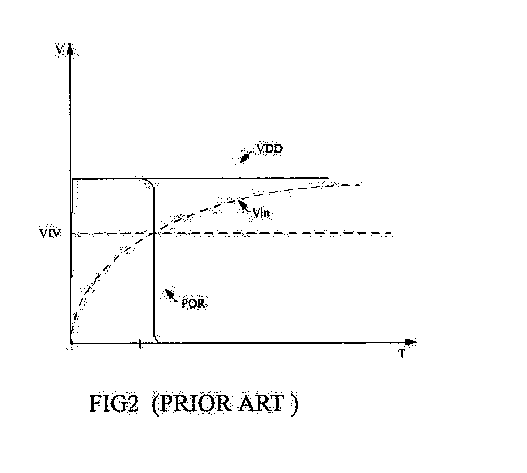

Figure 2 shows the operation of the conventional circuit in Figure 1

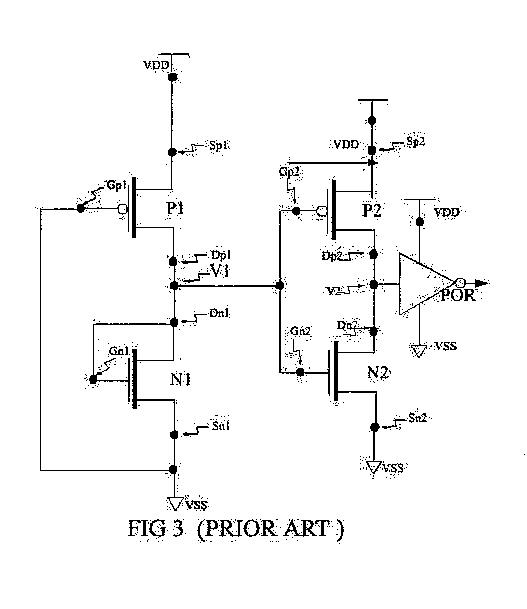

Figure 3 shows another conventional FOR circuit.

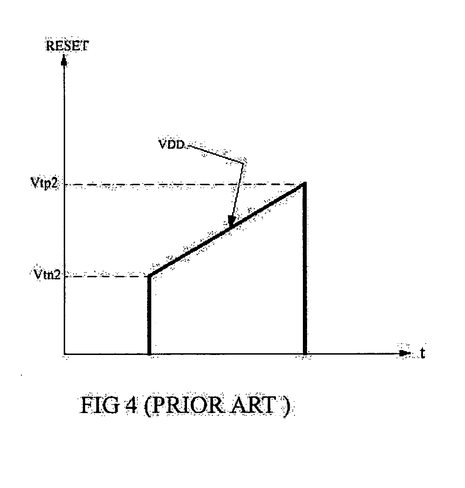

Figure 4 shows the behavior of the conventional circuit in Figure 3

Figure 5 shows an improved power On reset circuit, according to the present invention.

Figure 6 shows the operation of the circuit in Figure 5, according to the present invention.

Figure 7 shows the behavior of the circuit in Figure 5, according to the present invention.

**Detailed Description**

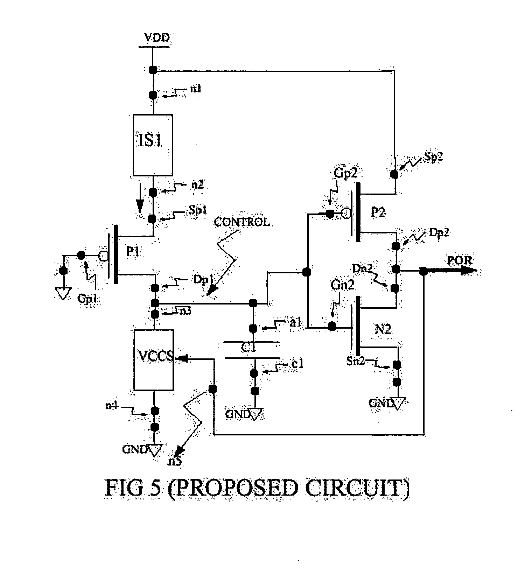

An improved power On reset circuit is shown in Figure 5. A current source, whose maximum current delivering capacity is l1, has one node 'n1' connected to the power supply positive terminal while another node 'n2' is connected to the source Sp1 of PMOS transistor P1.The gate Gp1 of PMOS transistor P1 is permanently connected to the power supply ground terminal while its drain Dp1 is connected to node 'control'. A Voltage Controlled Current Sink (VCCS) has one node 'n3' connected to node 'control', while a second node 'n4' is connected to the power supply ground terminal VSS while its control terminal node 'n5' is connected to the output terminal 'POR'. PMOS transistor P2 has its gate Gp2 connected to the 'control' node, while its Source Sp2 is connected to the power supply terminal VDD and its drain Dp2 is connected to the output terminal 'POR'. NMOS transistor N2 has its gate Gn2 connected to the 'control' node, and its source connected to the power supply ground terminal, while its drain Dn2 is connected to the output terminal 'POR'. Input Capacitor C1 has one terminal connected to the 'control' node while its other terminal is connected to the power supply ground terminal VSS.

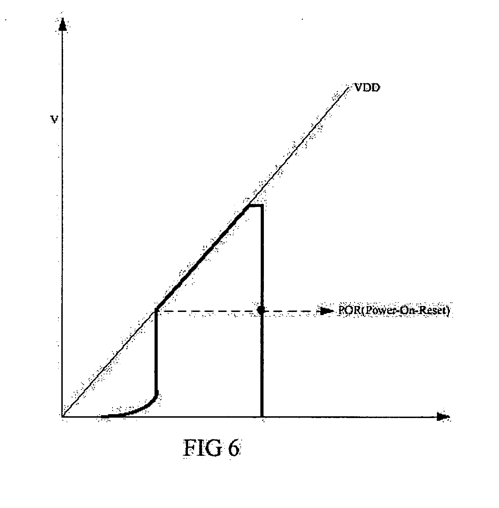

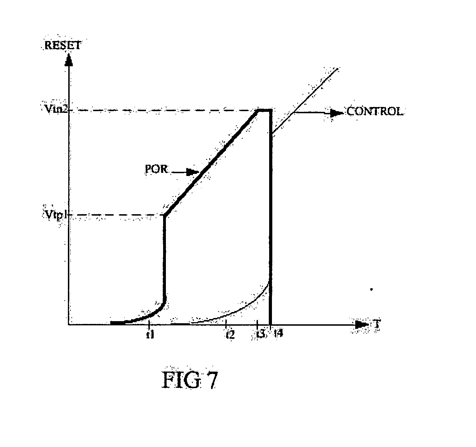

The operation of the instant circuit is described in figures 6 & 7. When the power supply is switched-on at a time T1 the 'control' node is at logic zero since the voltage control terminal of VCCS which is connected to output FOR is not sufficient to start the VCCS. PMOS transistor P1 now acts as an isolator between node 'n3' of the VCCS and node 'n2' of IS1 and thereby ensures that node 'n3' is in a high impedance state. Capacitor C1 further ensures that any noise pick-up does not disturb the zero logic level at the 'control' node. Additional safeguards against noise pick-up can be provided by shielding or guarding this net in the circuit layout design.

PMOS transistor P2 turns on at time 't1' when its Vgs is equal to its threshold voltage. The output node FOR will now follow VDD as it continues to increase. The output node FOR also controls the current provided by the VCCS which sinks current provided by IS1. At time T2 when the VCCS has started sinking current, switch P1 closes and node 'n2' connects to node 'n3'. At time t3 the current sinking capability of the VCCS is less then the current delivering capacity of the current from IS1 causing the voltage at the 'control' node to rise as the difference current charges the 'control' node.

At time t4 when the node 'control' has charged to a level which is equal to the threshold of NMOS transistor N2, transistor N2 turns ON and pulls down the output node FOR to VSS. This action is reinforced by Node 'n5' of VCCS also pulling low resulting in very low current in VCCS. Node 'n3' now charges up rapidly thereby accelerating N2 turn ON and pulling down the output 'POR' to VSS. At this time node 'n5' of VCCS is pulled down to VSS disabling it and blocking the current drawn from the power supply resulting in a power-down condition.

Capacitor C1 acts to delay the rise time of the 'control' node thereby making the operation unaffected by the rate of rise of the power supply voltage.

It will be apparent to those with ordinary skill in the art that the foregoing is merely illustrative intended to be exhaustive or limiting, having been presented by way of example only and that various modifications can be made within the scope of the above invention.

Accordingly, this invention is not to be considered limited to the specific examples chosen for purposes of disclosure, but rather to cover all changes and modifications, which do not constitute departures from the permissible scope of the present invention. The invention is therefore not limited by the description contained herein or by the drawings, but only by the claims.

**Claims**

1.  An improved Power-On-reset (POR) circuit providing enhanced reliability and automatic power-down capability, comprising:

    -   a supply voltage sensing circuit,
    -   a delay element connected to the output of the supply voltage sensing circuit, and
    -   a controlled switch that activates the output POR signal when the output of the delay element indicates a reduced supply voltage and deactivates the POR output and provides controlled feedback to reduce current through the supply voltage sensing circuit once the supply voltage is normal.

2.  An improved Power-On-reset (POR) circuit as claimed in claim 1 wherein the supply voltage sensing circuit is a constant current source connected to a current sink whose output is controlled by the feedback from the POR output.

3.  An improved Power-On-reset (POR) circuit as claimed in claim 1 wherein the delay element is a capacitor charged by the current difference between the constant current source and current sink.

4.  An improved Power-On-reset (POR) circuit as claimed in claim 1 wherein the controlled switch disables the current sink when the supply voltage is normal

5.  An improved Power-On-reset (POR) circuit as claimed in claim 2 wherein the constant current source is connected to the current sink through an isolating switch.

6.  An improved Power-On-reset (POR) circuit providing enhanced reliability and automatic power-down capability substantially as herein described with reference to and as illustrated in figures 5 to 7 of the accompanying drawings.

FIG. 1 ( PRIOR ART )

FIG2 (PRIOR ART)

FIG 3 (PRIOR ART)

FIG 4 (PRIOR ART)

FIG 5 (PROPOSED CIRCUIT)

FIG 6

FIG 7